# EUROPÄISCHE PATENTSCHRIFT

(11) **EP 3 493 940 B1**
(45) Veröffentlichungstag und Bekanntmachung des Hinweises auf die Patenterteilung: **15.02.2023**
(21) Anmeldenummer: 17748666.9
(22) Anmeldetag: 18.07.2017
(51) Int. Cl.: B23K 20/10, H01R 43/02, H02G 1/14, H01L 23/00, B23K 31/12, B23K 101/38

(54) **VORRICHTUNG UND VERFAHREN ZUR HERSTELLUNG EINER GEPRÜFTEN SCHWEISSVERBINDUNG**
DEVICE AND METHOD FOR PRODUCING A TESTED WELD JOINT
DISPOSITIF ET PROCÉDÉ DE RÉALISATION D'UN ASSEMBLAGE SOUDÉ TESTÉ

(30) Priorität: 02.08.2016 DE 102016214227
(43) Veröffentlichungstag der Anmeldung: 12.06.2019
(73) Patentinhaber: Schunk Sonosystems GmbH, 35435 Wettenberg (DE)
(72) Erfinder: WAGENBACH, Udo, 35418 Buseck (DE); SCHMIDT, Reiner, 35457 Lollar (DE); SCHUCH, Alexander, 35460 Staufenberg (DE); RUEHL, Sebastian, 35083 Wetter (DE); BECKER, Stephan, 35037 Marburg (DE)
(74) Vertreter: advotec.
(86) Internationale Anmeldenummer: PCT/EP2017/068154
(87) Internationale Veröffentlichungsnummer: WO 2018/024481

(56) Entgegenhaltungen:
- WO-A1-2005/042202
- DE-A1- 19 752 319
- DE-A1-102014 013 452
- US-B1- 6 564 115

## Beschreibung

Die vorliegende Erfindung betrifft eine Vorrichtung zur Herstellung einer geprüften Schweißverbindung zwischen zwei Kontaktpartnern, die in einer Schweißebene miteinander verbunden sind, umfassend einen Verdichtungsraum zur Aufnahme der Kontaktpartner, wobei der Verdichtungsraum in einer ersten Achsenrichtung an zwei einander gegenüberliegenden Seiten durch eine Arbeitsfläche einer Ultraschallschwingungen übertragenden Sonotrode und eine Gegenfläche einer Gegenelektrode sowie in einer zweiten Achsenrichtung an zwei einander gegenüberliegenden Seiten durch Begrenzungsflächen von einander gegenüberliegenden Begrenzungselementen begrenzt ist, und zumindest ein begrenzendes Element als Seitenschieberelement ausgebildet ist, das mittels einer Zustelleinrichtung gegenüber der Gegenelektrode verfahrbar ausgebildet ist. Darüber hinaus betrifft die Erfindung ein Verfahren zur Herstellung einer geprüften, in einer Schweißebene zwischen zwei Kontaktpartnern hergestellten Schweißverbindung.

Vorrichtungen der eingangs genannten Art werden bei der Anmelderin zur Herstellung einer nachfolgend als Terminalverbindung bezeichneten Schweißverbindung zwischen einem Anschlussende eines Drahtleiters und einer regelmäßig als Blechteil ausgebildeten, fachterminologisch häufig als Terminal bezeichneten Anschlusseinrichtung eingesetzt. Dabei bilden das Anschlussende des Drahtleiters und die Anschlusseinrichtung Kontaktpartner der Terminalverbindung, die in einer Schweißebene mittels der Ultraschweißverbindung miteinander verbunden sind.

Das Anschlussende des Drahtleiters kann dabei unmittelbar durch die Litze des Drahtleiters gebildet sein, die sich während der Ultraschallbeaufschlagung durch die Sonotrode in der Schweißebene flächig an eine Kontaktfahne der Anschlusseinrichtung anschmiegt, oder auch durch ein ebenfalls als Blechteil ausgebildetes Kontaktflächenelement, das zur Ausbildung des Anschlussendes des Drahtleiters vor Herstellung der Schweißverbindung mit der Litze des Drahtleiters verbunden wird. In diesem Fall sind beide Kontaktpartner aus einem Blechteil gebildet.

Zur Herstellung geprüfter Schweißverbindungen ist es aus der DE 10 2014 013 452 Al bekannt, während der Herstellung der Schweißverbindung im Verdichtungsraum die Prozessparameter oder auch die Geometrie der im Verdichtungsraum hergestellten Verbindungsanordnung in-situ zu überprüfen und bei Detektierung von Fehlern, also beispielsweise bei Überschreitung definierter Grenzwerte, automatisch eine Messereinrichtung zu aktivieren, um durch Abtrennen des Drahtleiters von dem Terminal eine nachfolgende Verwendung des fehlerhaft mit dem Terminal verschweißten Drahtleiters unmöglich zu machen.

Alternativ oder auch in Kombination mit der vorgenannten in-situ Überprüfung der Schweißverbindung mittels Überwachung von Prozessparametern oder der beim Schweißvorgang hergestellten Geometrie der Verbindungsanordnung werden bei Terminalverbindungen, bei denen das Anschlussende eines Drahtleiters mit einem Terminal verschweißt ist, zumindest Stichprobenartig mechanische Belastungstests der Verbindungsanordnung durchgeführt, um sicherzustellen, dass die Terminalverbindung auch den bei der bestimmungsgemäßen Verwendung der Terminalverbindung auftretenden mechanischen Belastungen Stand hält. Hierzu werden die Terminalverbindungen einem Schertest unterzogen, bei dem die Kontaktpartner in der Schweißebene und quer zur Längserstreckung des Drahtleiters mit einer Scherkraft beaufschlagt werden. Diese Tests werden bislang nachfolgend der Durchführung des Schweißvorgangs und nach Entfernung der im Schweißvorgang hergestellten Verbindunganordnung aus dem Verdichtungsraum durchgeführt. Hiermit ist ein zusätzliches Handling der Terminalverbindung verbunden, sodass wegen des damit verbundenen Aufwands in der Praxis nur relativ wenige Terminalverbindungen einer Losgröße geprüft werden.

Aus der WO 2005/042202 A1 ist eine Vorrichtung und ein Verfahren gemäß den Oberbegriffen der Ansprüche 1 und 13 bekannt.

Der vorliegenden Erfindung liegt die Aufgabe zugrunde, eine Vorrichtung sowie ein Verfahren vorzuschlagen, das die Durchführung mechanischer Tests an Terminalverbindungen vereinfacht.

Zur Lösung dieser Aufgabe weist die erfindungsgemäße Vorrichtung die Merkmale des Anspruchs 1 auf.

Erfindungsgemäß weist die Vorrichtung benachbart dem Verdichtungsraum einen Prüfkopf auf, der mit einer Zustelleinrichtung zur Zustellung des Prüfkopfs in Richtung einer zur Schweißebene parallelen Zustellachse versehen ist, und die Gegenfläche dient zur fixierenden Aufnahme eines Kontaktpartners in Richtung der Zustellachse, wobei der Prüfkopf aus einer Position außerhalb des Verdichtungsraums in eine Position innerhalb des Verdichtungsraums überführbar ist, derart, dass der Prüfkopf in einem Prüfmodus der Vorrichtung zur Beaufschlagung des anderen Kontaktpartners der zuvor hergestellten Schweißverbindung mit einer im Wesentlich parallel zur Schweißebene gerichteten Scherkraft innerhalb des geöffneten Verdichtungsraums angeordnet ist, und der Prüfkopf in einem Schweißmodus der Vorrichtung zur Herstellung der Schweißverbindung außerhalb des Verdichtungsraums angeordnet ist. Die erfindungsgemäße Vorrichtung ermöglicht demnach die Durchführung der mechanischen Prüfung der Terminalverbindung noch während sich die Terminalverbindung im Verdichtungsraum befindet. Eine gesonderte Handhabung der Terminalverbindung zur Durchführung des mechanischen Tests ist demnach nicht notwendig. Vielmehr verbleibt die Terminalverbindung nach Durchführung des Schweißvorgangs an Ort und Stelle im Verbindungsraum und wird erst nach Durchführung des mechanischen Tests dem Verbindungsraum entnommen. Somit kann die Anzahl der tatsächlich überprüften Terminalverbindungen einer Losgröße wesentlich erhöht werden, ohne dass hiermit eine wesentliche Erhöhung der Fertigungszeit einer Losgröße verbunden wäre.

Erfindungsgemäß ist die Zustelleinrichtung des Prüfkopfs durch die Zustelleinrichtung des Seitenschieberelements gebildet, so dass für die Zustellung des Prüfkopfs keine separate Zustelleinrichtung vorzusehen ist.

Wenn der Prüfkopf am Seitenschieberelement angeordnet ist, kann dieses zur Montage des Prüfkopfs genutzt werden.

In einer bevorzugten Ausführungsform ist der Prüfkopf an einem austauschbar mit einem Seitenschieberträger eines Seitenschieberelements verbundenen Seitenschieberkopf angeordnet, sodass eine Nachrüstung einer standardmäßig zur Herstellung von Terminalverbindungen verwendeten Schweißvorrichtung durch einfachen Austausch des Seitenschieberkopfs möglich ist.

Wenn der Prüfkopf verschwenkbar an das Seitenschieberelement angeschlossen ist, lässt sich die Überführung des Prüfkopfs in den Verdichtungsraum innerhalb kürzester Zeit vornehmen.

Besonders vorteilhaft ist es dabei, wenn der Prüfkopf mittels einer parallel zur Gegenfläche der Gegenelektrode und in eine dritte Achsenrichtung quer zur Zustellrichtung des Seitenschieberelements verlaufenden Schwenkachse an das Seitenschieberelement angeschlossen ist, sodass eine Antriebseinrichtung zum Verschwenken des Prüfkopfs oberhalb des Seitenschieberelements vorgesehen werden kann und somit die Zugänglichkeit des Verdichtungsraums möglichst wenig beeinträchtigt.

Eine besonders kompakte Lösung zur Anordnung des Prüfkopfs in unmittelbarer Nähe des Verdichtungsraums ergibt sich, wenn der Prüfkopf mittels einer am Seitenschieberelement angeordneten Antriebseinrichtung gegenüber dem Seitenschieberelement verschwenkbar ist.

Vorzugsweise weist der Prüfkopf eine Kontaktpartneraufnahme auf mit einem im Wesentlichen parallel zur Schweißebene angeordneten Niederhalter und einer Krafteinleitungseinrichtung zur Kraftübertragung auf den Kontaktpartner. Mittels eines derart ausgebildeten Prüfkopfs ist sichergestellt, dass die vom Prüfkopf auf den Kontaktpartner wirkende Prüfkraft innerhalb der Schweißebene wirkt, da insbesondere aufgrund der Ausbildung der Kontaktpartneraufnahme verhindert wird, dass der mit der Prüfkraft beaufschlagte Kontaktpartner vom anderen Kontaktpartner abhebt.

Wenn die Kontaktaufnahme eine in der ersten Achsenrichtung wirksame Dreharretierung aufweist, kann anderseits bei Bedarf auch verhindert werden, dass der mit der Prüfkraft beaufschlagte Kontaktpartner sich in der Schweißebene gegenüber dem anderen Kontaktpartner verdreht.

Vorzugsweise ist der Niederhalter als eine parallel zur Schweißebene S angeordnete Anlagefläche, die Dreharretierung als eine Anlagekante und die Krafteinleitungseinrichtung als Anschlagkante ausgebildet, sodass der Niederhalter, die Dreharretierung und die Beaufschlagungsfläche eine definierte Raumecke ausbilden und die Prüfkraft gleichmäßig über die gesamte Breite des Kontaktpartners übertragen und ein Verdrehen des Kontaktpartners ausgeschlossen ist.

Besonders bevorzugt ist es, wenn benachbart dem Verdichtungsraum eine Bearbeitungseinrichtung angeordnet ist, die eine dem Prüfvorgang nachfolgende Bearbeitung eines mit einem Kontaktpartner verbundenen Drahtleiters oder eines mit dem Kontaktpartner verbundenen Terminals ermöglicht.

Vorzugsweise ist die Bearbeitungseinrichtung als Trenneinrichtung zum Durchtrennen des Drahtleiters ausgebildet, sodass für den Fall eines Versagens der Verbindungsanordnung im Schertest unmittelbar nachfolgend eine Durchtrennung des Drahtleiters zur Unbrauchbarmachung der Verbindungsanordnung erfolgen kann.

Ebenso vorteilhaft kann es sein, wenn die Bearbeitungseinrichtung als Umformeinrichtung zur Umformung des Terminals ausgebildet ist, sodass im Falle eines Versagens der Verbindungsanordnung im Schertest eine Umformung des Terminals erfolgen oder unterbleiben kann, um die Verbindungsanordnung als unbrauchbar zu kennzeichnen.

Zur Lösung der der Erfindung zu Grunde liegenden Aufgabe weist das erfindungsgemäße Verfahren die Merkmale des Anspruchs 13 auf.

Erfindungsgemäß wird zur Durchführung des dem Schweißvorgang nachfolgenden Prüfvorgangs ein Prüfkopf, der während des im Schweißmodus der Vorrichtung durchgeführten Schweißvorgangs, in dem der Verdichtungsraum durch die Sonotrode geschlossen ist, außerhalb des Verdichtungsraums angeordnet ist, in einem Prüfmodus der Vorrichtung, in dem der Verdichtungsraum geöffnet ist, in eine Position innerhalb des Verdichtungsraums gebracht, wobei zur Durchführung der Prüfung ein Kontaktpartner der in Schweißposition verbliebenen Schweißverbindung mit einer Scherkraft in Richtung einer Zustellachse des Prüfkopfs beaufschlagt und der andere Kontaktpartner auf der Gegenfläche entgegen der Zustellrichtung des Prüfkopfs fixiert gehalten wird.

Vorzugsweise wird der Prüfkopf zur Durchführung des Prüfvorgangs im Prüfmodus der Vorrichtung aus einer im Schweißmodus der Vorrichtung oberhalb des Seitenschieberelements angeordneten Position in eine Prüfstellung in den geöffneten Verdichtungsraum eingeschwenkt.

Wenn die Durchführung des Prüfvorgangs in Abhängigkeit von zumindest einem während des Schweißvorgangs ermittelten Prozessparameter erfolgt, kann die Prüfung unabhängig von einem festen Prüfraster, das beispielsweise eine definierte Prüffrequenz vorsieht, derart, dass jede x-te Terminalverbindung geprüft wird, immer dann erfolgen, wenn signifikante Abweichungen in einem Prozessparameter festgestellt werden. Derartige Prozessparameter können beispielsweise die Leistungsaufnahme der Sonotrode bzw. eines an die Sonotrode angeschlossenen Konverters, die Schweißzeit oder auch ein geometrischer Parameter der Schweißverbindung sein.

Vorzugsweise wird zur Durchführung des Prüfvorgangs eine Krafteinleitungseinrichtung des Prüfkopfs auf Anschlag gegen den Kontaktpartner verfahren, und anschließend erfolgt eine kontinuierliche Erhöhung der Kraft.

Wenn die Zustelleinrichtung des Prüfkopfs mit einer Wegmesseinrichtung versehen ist, derart, dass während der Erhöhung der Kraft der Zustellweg des Prüfkopfs gemessen wird, kann insbesondere in dem Fall, dass ein Kontaktpartner als Litze ausgebildet ist, eine Schlechtteildefinition der Terminalverbindung bei zu großer Komprimierbarkeit des Kontaktpartners, also etwa bei zu großer Abweichung von einen vorgegebenen Kraft-/Weg-Gradienten, erfolgen.

Unabhängig von dem zur Schlechtteildefinition bestimmten Parameter ist es zur Dokumentation des Prüfvorgangs und/oder des Prüfergebnisses von Vorteil, wenn parallel zum Prüfvorgang eine Dokumentation mit Speicherung der relevanten Daten und deren Zuordnung zur geprüften Terminalverbindung, insbesondere die Erstellung einer Logdatei, erfolgt.

Wenn bei Durchführung des Prüfvorgangs eine Kennzeichnung eines Kontaktpartners mit einem Prüfkennzeichen erfolgt, kann gleichzeitig mit Durchführung des Prüfvorgangs ein Nachweis für die erfolgte Prüfung ermöglicht werden.

Vorzugsweise erfolgt während des Prüfvorgangs eine Kraftmessung der durch den Prüfkopf aufgebrachten Kraft um im Falle eines Unterschreitens einer definierten Prüfkraft eine Durchtrennung eines mit dem Kontaktpartner verbundenen Drahtleiters mittels einer Trenneinrichtung.

Alternativ kann während des Prüfvorgangs eine Kraftmessung der durch den Prüfkopf aufgebrachten Scherkraft erfolgen und im Falle einer Unterschreitung einer als Sollwert definierten Prüfkraft die Umformung eines Kontaktpartners zur Herstellung einer mechanischen Verbindung zwischen dem Kontaktpartner und einem mit dem Kontaktpartner verbundenen Drahtleiter mittels einer auf den Kontaktpartner einwirkenden Umformeinrichtung unterbleiben.

Nachfolgend wird eine bevorzugte Ausführungsform der Vorrichtung mit Erläuterung des mittels der Vorrichtung durchführbaren Verfahrens anhand der Zeichnung näher erläutert.

Es zeigen:
- **Fig. 1**: eine Vorrichtung gemäß dem Stand der Technik mit einem geschlossenen Verdichtungsraum;
- **Fig. 2**: die Vorrichtung gemäß dem Stand der Technik mit geöffnetem Verdichtungsraum;
- **Fig. 3**: eine Ausführungsform der erfindungsgemäßen Vorrichtung mit einem außerhalb des Verdichtungsraums angeordneten Prüfkopf;
- **Fig. 4**: die in **Fig. 3** dargestellte Vorrichtung mit in den Verdichtungsraum verschwenktem Prüfkopf.

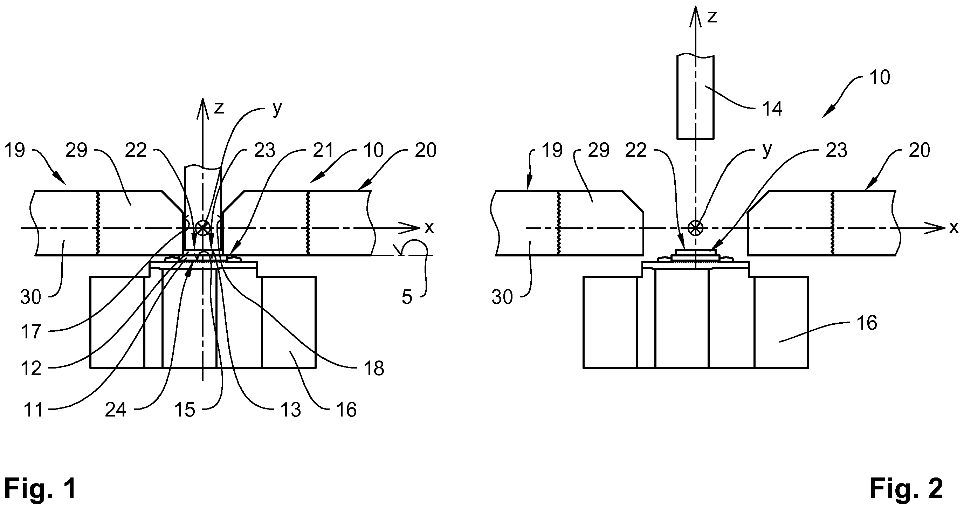

**Fig. 1** zeigt einen Verdichtungsraum 10 einer Vorrichtung gemäß dem Stand der Technik während der Durchführung eines Ultraschallschweißvorgangs. Der Verdichtungsraum 10 nimmt während der Durchführung des Schweißvorgangs einen unteren Kontaktpartner 11 sowie einen oberen Kontaktpartner 12 auf und ist in einer hier durch die Z-Achse definierten ersten Achsenrichtung an zwei einander gegenüberliegenden Seiten durch eine Arbeitsfläche 13 einer hier senkrecht zur Zeichenebene in Richtung der Y-Achse mit Ultraschallschwingungen beaufschlagten Sonotrode 14 und einer Gegenfläche 15 einer als Amboss ausgebildeten Gegenelektrode 16 begrenzt.

In einer zweiten, hier durch die X-Achse definierten Achsenrichtung ist der Verdichtungsraum 10 von einander gegenüberliegenden Begrenzungsflächen 17, 18 von Begrenzungselementen begrenzt, die durch jeweils ein Seitenschieberelement 19, 20 gebildet sind, welche, wie insbesondere in **Fig. 2** dargestellt, im vorliegenden Fall beide gegenüber der Gegenelektrode 16 in Richtung der X-Achse verfahrbar sind.

In dem in **Fig. 1** dargestellten Schweißmodus, in dem sich die Kontaktpartner 11, 12 in definierter Anordnung aufeinanderliegend in Schweißposition befinden, ist der untere Kontaktpartner 11 in eine den Kontaktpartner 11 in Richtung der X-Achse fixierenden Ambossaufnahme 21 aufgenommen. Zwischen dem unteren Kontaktpartner 11 und der Arbeitsfläche 13 der Sonotrode 14 befindet sich der obere Kontaktpartner 12, der von der Sonotrode 14 mit definiertem Druck gegen den unteren Kontaktpartner 11 gedrückt wird. Die Relativposition des oberen Kontaktpartners 12 gegenüber dem unteren Kontaktpartner 11 wird im Schweißmodus durch die in Richtung der X-Achse gegen den oberen Kontaktpartner 12 verfahrenen Begrenzungsflächen 17, 18 der Seitenschieberelemente 19, 20 definiert. In dieser Relativanordnung der Kontaktpartner 11, 12 innerhalb des geschlossenen Verdichtungsraums 10 bewirkt eine Schwingungsbeaufschlagung der Sonotrode 14 ein Verschweißen der Kontaktpartner 11, 12 in einer zwischen den Kontaktpartnern 11, 12 ausgebildeten Schweißebene S.

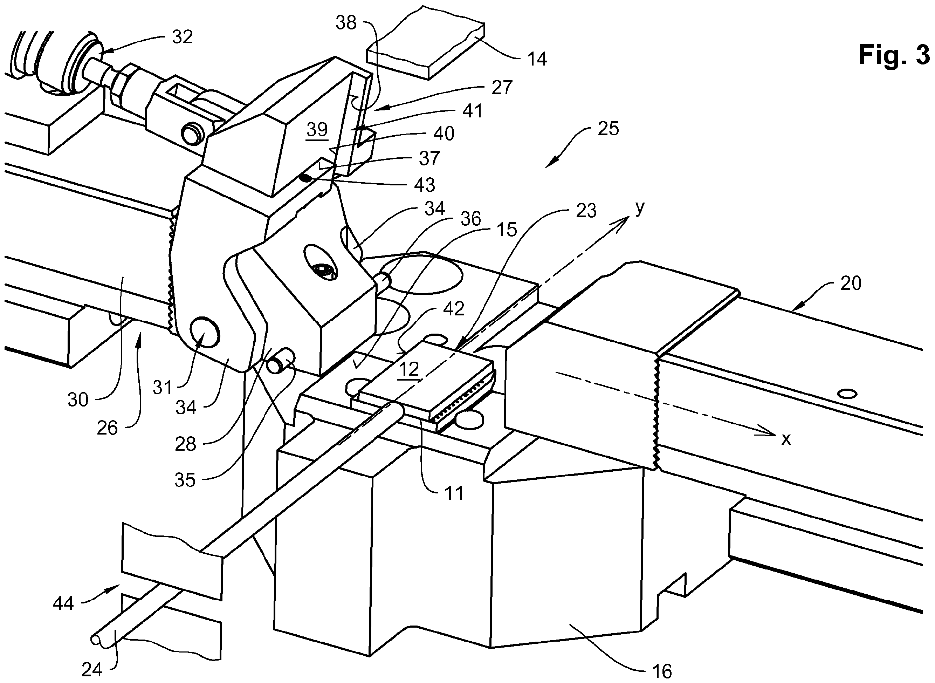

Bei den in den **Fig. 1** und **2** dargestellten Kontaktpartnern 11, 12 handelt es sich im vorliegenden Fall bei dem unteren Kontaktpartner 11 um ein Anschlussende eines aus Blech hergestellten Terminals 22, und bei dem oberen Kontaktpartner 12 um ein infolge der Druckbeaufschlagung durch die Sonotrode 14 im Querschnitt annähernd rechteckförmig verdichtetes Litzenende eines mit dem Terminal 22 zur Herstellung einer Terminalverbindung 23 verbundenen Drahtleiters 24 **(****Fig. 3****).**

Nach Herstellung der Schweißverbindung in dem in **Fig. 1** dargestellten Verdichtungsraum 10 erfolgt eine Öffnung des Verdichtungsraums 10, wie in **Fig. 2** dargestellt, derart, dass sowohl die Seitenschieberelemente 19, 20 in Richtung der X-Achse als auch die Sonotrode 14 in Richtung der Z-Achse verfahren wird und eine Entnahme der fertiggestellten Terminalverbindung 23 aus dem Verdichtungsraum 10 erfolgen kann.

**Fig. 3** zeigt eine Ausführungsform der erfindungsgemäßen Vorrichtung mit einem Verdichtungsraum 25 in isometrischer Darstellung in einer **Fig. 2** entsprechenden Konfiguration, also nach Durchführung des Schweißvorgangs mit einer noch in Schweißposition im Verdichtungsraum 25 angeordneten Terminalverbindung 23, wobei in **Fig. 3** übereinstimmend mit dem in **Fig. 2** dargestellten Verdichtungsraum 10 ausgebildete Komponenten identische Bezugszeichen aufweisen.

Wie ein Vergleich der **Fig. 3** und **2** deutlich macht, weist der Verdichtungsraum 25 abweichend von dem Verdichtungsraum 10 ein Seitenschieberelement 26 auf, das mit einem Prüfkopf 27 versehen ist. Der Prüfkopf 27 ist an einem Seitenschieberkopf 28 angeordnet, der wie ein Seitenschieberkopf 29 des Seitenschieberelements 19 austauschbar an einem Seitenschieberträger 30 angeordnet ist.

Wie **Fig. 3** zeigt, ist der Prüfkopf 27 an einer quer zur Zustellrichtung des Seitenschieberelements 26, also hier quer zur X-Achse und parallel zur Gegenfläche 15 der Gegenelektrode 16 verlaufenden Schwenkachse 31 am Seitenschieberkopf 28 gelagert. Als Schwenkantrieb für den Prüfkopf 27 ist dieser mit einer hier als Pneumatikzylinder ausgebildeten Antriebseinrichtung 32 verbunden, die auf dem Seitenschieberträger 30 angeordnet ist.

**Fig. 3** zeigt den Prüfkopf 27 in einer Relativanordnung am Seitenschieberelement 26 außerhalb des Verdichtungsraums 25, in der der Prüfkopf 27 während der Durchführung des Schweißvorgangs, also während sich die Schweißvorrichtung im Schweißmodus befindet, angeordnet ist. Nach Überführung des Verdichtungsraums 25 in die in **Fig. 3** dargestellte geöffnete Stellung, in der sich die Seitenschieberelemente 26, 20 beabstandet zu den Kontaktpartnern 11, 12 befinden und die Sonotrode 14 nach oben von den Kontaktpartnern 11, 12 abgehoben ist, verbleibt nachfolgend dem Schweißvorgang die Terminalverbindung 23 mit den in der Schweißebene S miteinander verschweißten Kontaktpartnern 11, 12 in Schweißposition auf der Gegenelektrode 16, wobei der untere Kontaktpartner 11 in der Ambossaufnahme 21 in Richtung der X-Achse fixiert bleibt.

Ausgehend von der in **Fig. 3** dargestellten Nichtbetriebsstellung wird zur Durchführung eines Prüfvorgangs der Prüfkopf 27 in seine Betriebs- oder Prüfstellung verschwenkt, wobei die Prüfstellung des Prüfkopfs 27 im Fall des vorliegenden Ausführungsbeispiels durch einen Anschlag von an der Schwenkachse 31 gelenkig gelagerten Schwenkarmen 33, 34 des Prüfkopfs gegen am Seitenschieberkopf 28 angeordnete Schwenkanschläge 35, 36 definiert ist. Ausgehend von dieser Prüfstellung des Prüfkopfs 27 wird der Prüfkopf 27 mit einer in **Fig. 3** dargestellten Anschlagkante 37, die zusammen mit einer Anlagekante 38 und einer Anlagefläche 39, die jeweils senkrecht zur Anschlagkante 37 orientiert sind und mit der Anschlagkante 37 an einer Unterseite 40 des Prüfkopfs 27 eine als Raumecke ausgebildete Kontaktpartneraufnahme 41 ausbilden, gegen eine in Richtung der Y-Achse verlaufende Längskante 42 des oberen Kontaktpartners 12 verfahren.

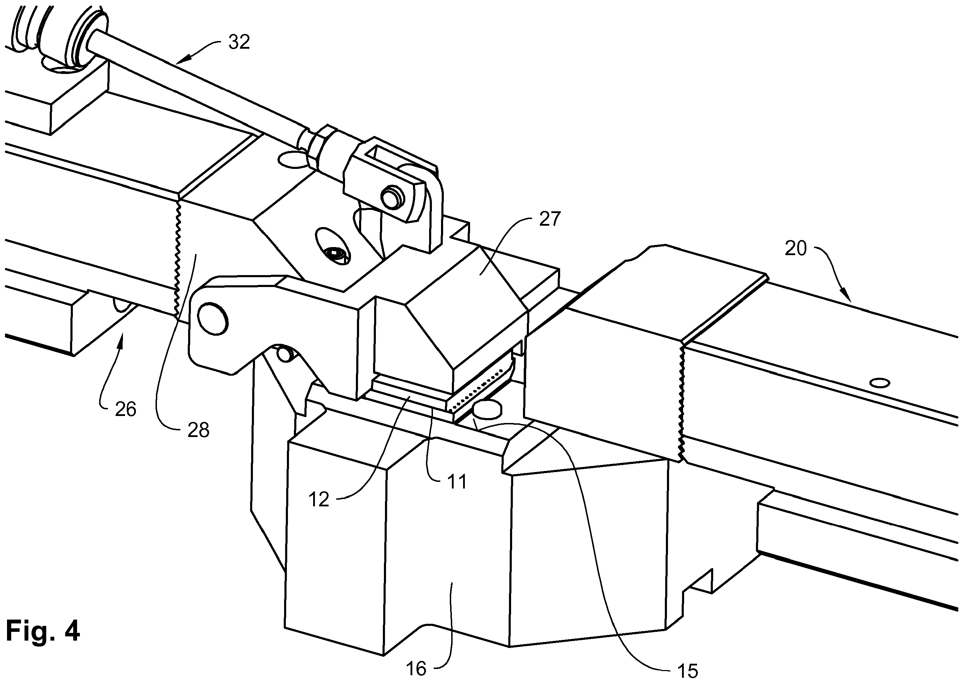

Wie **Fig. 4** zeigt, ist in der nach Anlage der Anschlagkante 37 gegen die Längskante 42 des oberen Kontaktpartners 12 erreichten Krafteinleitungsstellung des Prüfkopfs 27 der obere Kontaktpartner 12 derart in der am Prüfkopf 27 ausgebildeten Kontaktpartneraufnahme 41 aufgenommen, dass die Anlagefläche 39 als Niederhalter und die Anlagekante 38 als Verdrehsicherung wirkt. Somit wird in dem Fall, dass der obere Kontaktpartners 12 durch Betätigung der Zustelleinrichtung des Seitenschieberelements 26 in Richtung der X-Achse mit einer Querkraft beaufschlagt wird, die in der Schweißebene S eine Scherkraft bewirkt, ein Ausweichen des oberen Kontaktpartners 12 in Richtung der Z-Achse und der Y-Achse verhindert und lediglich in Richtung der X-Achse ermöglicht.

Wie in **Fig. 3** dargestellt, ist die Anschlagkante 37 mit einem Prüfstempel 43 versehen, der die Aufbringung einer Prüfkennzeichnung auf den oberen Kontaktpartner 12 ermöglicht. Im Falle einer Unterschreitung einer als Sollwert definierten Prüfkraft kann mittels einer in Richtung der Y-Achse, wie in **Fig. 3** dargestellt, unmittelbar benachbart dem Verdichtungsraum 25 angeordneten Trenneinrichtung 44 eine Durchtrennung des mit dem oberen Kontaktpartner 12 verbundenen Drahtleiters 24 erfolgen, um eine Verwendung einer durch Unterschreiten der Prüfkraft als fehlerhaft erkannten Terminalverbindung 23 zu verhindern.

## Patentansprüche

1. Vorrichtung zur Herstellung einer geprüften Schweißverbindung zwischen zwei Kontaktpartnern (11, 12), die in einer Schweißebene S miteinander verbunden sind, umfassend einen Verdichtungsraum (25) zur Aufnahme der Kontaktpartner (11, 12), wobei der Verdichtungsraum (25) in einer ersten Achsenrichtung an zwei einander gegenüberliegenden Seiten durch eine Arbeitsfläche (13) einer Ultraschallschwingungen übertragenden Sonotrode (14) und eine Gegenfläche (15) einer Gegenelektrode (16) sowie in einer zweiten Achsenrichtung an zwei einander gegenüberliegenden Seiten durch Begrenzungsflächen (17, 18) von einander gegenüberliegenden Begrenzungselementen begrenzt ist, und zumindest ein Begrenzungselement als Seitenschieberelement (26) ausgebildet ist, das mittels einer Zustelleinrichtung gegenüber der Gegenelektrode (16) verfahrbar ausgebildet ist,
**dadurch gekennzeichnet,**
**dass** die Vorrichtung benachbart dem Verdichtungsraum (25) einen Prüfkopf (27) aufweist, der mit einer Zustelleinrichtung zur Zustellung des Prüfkopfs (27) in Richtung einer zur Schweißebene S parallelen Zustellachse versehen ist, und die Gegenfläche (15) zur fixierenden Aufnahme eines Kontaktpartners (11) in Richtung der Zustellachse dient, wobei der Prüfkopf aus einer Position außerhalb des Verdichtungsraums in eine Position innerhalb des Verdichtungsraums überführbar ist, derart, dass der Prüfkopf (27) in einem Prüfmodus der Vorrichtung zur Beaufschlagung des anderen Kontaktpartners (12) der zuvor hergestellten Schweißverbindung mit einer im Wesentlichen parallel zur Schweißebene S gerichteten Scherkraft innerhalb des geöffneten Verdichtungsraums (25) angeordnet ist, und der Prüfkopf (27) in einem Schweißmodus der Vorrichtung zur Herstellung der Schweißverbindung außerhalb des Verdichtungsraums (25) angeordnet ist, wobei die Zustelleinrichtung des Prüfkopfs (27) durch die Zustelleinrichtung des Seitenschieberelements (26) gebildet ist.

2. Vorrichtung nach Anspruch 1,
**dadurch gekennzeichnet,**
**dass** der Prüfkopf (27) am Seitenschieberelement (26) angeordnet ist.

3. Vorrichtung nach Anspruch 1 oder 2,
**dadurch gekennzeichnet,**
**dass** der Prüfkopf (27) an einem austauschbar mit einem Seitenschieberträger (30) des Seitenschieberelements (26) verbundenen Seitenschieberkopf (28) angeordnet ist.

4. Vorrichtung nach Anspruch 2 oder 3,
**dadurch gekennzeichnet,**
**dass** der Prüfkopf (27) verschwenkbar an das Seitenschieberelement (26) angeschlossen ist.

5. Vorrichtung nach Anspruch 4,
**dadurch gekennzeichnet,**
**dass** der Prüfkopf (27) mittels einer parallel zur Gegenfläche (15) der Gegenelektrode (16) und in eine dritte Achsenrichtung quer zur Zustellrichtung des Seitenschieberelements (26) verlaufenden Schwenkachse (31) an das Seitenschieberelement (26) angeschlossen ist.

6. Vorrichtung nach Anspruch 5,
**dadurch gekennzeichnet,**
**dass** der Prüfkopf (27) mittels einer am Seitenschieberelement (26) angeordneten Antriebseinrichtung (32) gegenüber dem Seitenschieberelement (26) verschwenkbar ist.

7. Vorrichtung nach einem der vorangehenden Ansprüche,
**dadurch gekennzeichnet,**
**dass** der Prüfkopf (27) eine Kontaktpartneraufnahme (41) aufweist mit einem im Wesentlichen parallel zur Schweißebene S angeordneten Niederhalter und einer Krafteinleitungseinrichtung zur Kraftübertragung auf den Kontaktpartner (12).

8. Vorrichtung nach Anspruch 7,
**dadurch gekennzeichnet,**
**dass** die Kontaktpartneraufnahme eine gegenüber einer Drehung um die erste Achsenrichtung wirksame Dreharretierung aufweist.

9. Vorrichtung nach Anspruch 7,
**dadurch gekennzeichnet,**
**dass** der Niederhalter als eine parallel zur Schweißebene S angeordnete Anlagefläche (39), die Dreharretierung als eine Anlagekante (38) und die Krafteinleitungseinrichtung als Anschlagkante (37) ausgebildet ist.

10. Vorrichtung nach einem der vorangehenden Ansprüche,
**dadurch gekennzeichnet,**
**dass** benachbart dem Verdichtungsraum (25) eine Bearbeitungseinrichtung angeordnet ist, die eine dem Prüfvorgang nachfolgende Bearbeitung eines mit einem Kontaktpartner (12) verbundenen Drahtleiters (43) oder eines mit dem Kontaktpartner verbundenen Terminals (22) ermöglicht.

11. Vorrichtung nach Anspruch 10,
**dadurch gekennzeichnet,**
**dass** die Bearbeitungseinrichtung als Trenneinrichtung (44) zum Durchtrennen des Drahtleiters (22) ausgebildet ist.

12. Vorrichtung nach Anspruch 11,
**dadurch gekennzeichnet,**
**dass** die Bearbeitungseinrichtung als Umformeinrichtung zur Umformung des Terminals (22) ausgebildet ist.

13. Verfahren zur Herstellung einer geprüften, in einer Schweißebene S zwischen Kontaktpartnern (11, 12) hergestellten Schweißverbindung, wobei nachfolgend einem in einem Verdichtungsraum (25), der in einer ersten Achsenrichtung an zwei einander gegenüberliegenden Seiten durch eine Arbeitsfläche (13) einer Ultraschallschwingungen übertragenden Sonotrode (14) und eine Gegenfläche (15) einer Gegenelektrode (16) sowie in einer zweiten Achsenrichtung an zwei einander gegenüberliegenden Seiten durch Begrenzungsflächen (17, 18) von einander gegenüberliegenden Begrenzungselementen begrenzt ist, in einer Schweißposition der Kontaktpartner (11, 12) durchgeführten Schweißvorgang der Verdichtungsraum (25) geöffnet wird, **dadurch gekennzeichnet,**
**dass** zur Durchführung eines dem Schweißvorgang nachfolgenden Prüfvorgangs ein Prüfkopf (27), der während des im Schweißmodus der Vorrichtung durchgeführten Schweißvorgangs, in dem der Verdichtungsraum (25) durch die Sonotrode (14) geschlossen ist, außerhalb des Verdichtungsraums angeordnet ist, in einem Prüfmodus der Vorrichtung, in dem der Verdichtungsraum (25) geöffnet ist, in eine Position innerhalb des geöffneten Verdichtungsraums gebracht wird, wobei zur Durchführung des Prüfvorgangs ein Kontaktpartner (12) der in Schweißposition verbliebenen Schweißverbindung mit einer Scherkraft in Richtung einer Zustellachse des Prüfkopfs beaufschlagt und der andere Kontaktpartner (11) auf der Gegenfläche (15) entgegen der Zustellrichtung des Prüfkopfs (27) fixiert gehalten wird, wobei die Durchführung des Prüfvorgangs in Abhängigkeit von zumindest einem während des Schweißvorgangs ermittelten Prozessparameter erfolgt.

14. Verfahren nach Anspruch 13,
**dadurch gekennzeichnet,**
**dass** zur Durchführung des Prüfvorgangs im Prüfmodus der Vorrichtung der Prüfkopf (27) aus einer im Schweißmodus der Vorrichtung oberhalb des Seitenschieberelements (26) angeordneten Position in eine Prüfstellung in den geöffneten Verdichtungsraum (25) eingeschwenkt wird.

15. Verfahren nach Anspruch 14,
**dadurch gekennzeichnet,**
**dass** zur Durchführung des Prüfvorgangs eine Krafteinleitungseinrichtung des Prüfkopfs (27) auf Anschlag gegen den Kontaktpartner (12) verfahren wird, und anschließend eine kontinuierliche Erhöhung der Kraft erfolgt.

16. Verfahren nach Anspruch 15,
**dadurch gekennzeichnet,**
**dass** die Zustelleinrichtung des Prüfkopfs mit einer Wegmesseinrichtung versehen ist, derart, dass während der Erhöhung der Kraft der Zustellweg des Prüfkopfs (27) gemessen wird.

17. Verfahren nach einem der Ansprüche 13 bis 16,
**dadurch gekennzeichnet,**
**dass** bei Durchführung des Prüfvorgangs eine Kennzeichnung eines Kontaktpartners (12) mit einem Prüfkennzeichen erfolgt.

18. Verfahren nach einem der Ansprüche 13 bis 17,
**dadurch gekennzeichnet,**
**dass** während des Prüfvorgangs eine Kraftmessung der durch den Prüfkopf (27) aufgebrachten Kraft und/oder eine Wegmessung des Zustellwegs des Prüfkopfs (27) erfolgt, und im Falle einer Unterschreitung einer als Sollwert definierten Prüfkraft oder Überschreitung eines als Maximalweg definierten Zustellwegs eine Durchtrennung eines mit einem Kontaktpartner (12) verbundenen Drahtleiters (24) mittels einer Trenneinrichtung (44) erfolgt.

19. Verfahren nach einem der Ansprüche 13 bis 17,
**dadurch gekennzeichnet,**
**dass** während des Prüfvorgangs eine Kraftmessung der durch den Prüfkopf (27) aufgebrachten Kraft und/oder eine Wegmessung des Zustellwegs des Prüfkopfs (27) erfolgt, und im Falle einer Unterschreitung einer als Sollwert definierten Prüfkraft oder Überschreitung eines als Maximalweg definierten Zustellwegs eine Umformung eines Kontaktpartners (11, 12) zur Herstellung einer mechanischen Verbindung zwischen dem Kontaktpartner und einem mit dem Kontaktpartner verbundenen Drahtleiter (22) mittels einer auf den Kontaktpartner (12) einwirkenden Umformeinrichtung unterbleibt.

## Claims

1. A device for producing a tested weld joint between two contact elements (11, 12) joined together in a welding plane S, the device comprising a compressing space (25) for accommodating the contact elements (11, 12), said compressing space (25) being delimited by a work surface (13) of a sonotrode (14), which transmits ultrasonic oscillations, and a counter-surface (15) of a counter-electrode (16) in a first axial direction at two opposing sides and by delimiting surfaces (17, 18) of opposing delimiting elements in a second axial direction at two opposing sides, and at least one delimiting element being realized as a lateral slider element (26) which is realized so as to be displaceable by means of an advancing device with respect to the counter-electrode (16),
**characterized in that**
the device comprises a test head (27) which is next to the compressing space (25) and is provided with an advancing device for advancing the test head (27) towards an advancing axis parallel to the welding plane S, and **in that** the counter-surface (15) serves for accommodating a contact element (11) in a fixating manner in the direction of the advancing axis, said test head being able to be transferred from a position outside of the compressing space to a position within the compressing space in such a manner that the test head (27) is disposed within the open compressing space (25) in a test mode of the device for subjecting the other contact element (12) of the previously produced weld joint to a shear force oriented essentially parallel to the welding plane S, and **in that** the test head (27) is disposed outside of the compressing space (25) in a welding mode of the device for producing the weld joint, the advancing device of the test head (27) being formed by the advancing device of the lateral slider element (26).

2. The device according to claim 1,
**characterized in that**
the test head (27) is disposed at the lateral slider element (26).

3. The device according to claim 1 or 2,
**characterized in that**
the test head (27) is disposed on a lateral slider head (28) connected to a lateral slider carrier (30) of the lateral slider element (26) in an exchangeable manner.

4. The device according to claim 2 or 3,
**characterized in that**
the test head (27) is connected to the lateral slider element (26) in a pivotable manner.

5. The device according to claim 4,
**characterized in that**
the test head (27) is connected to the lateral slider element (26) by means of a pivot axis (31) extending parallel to the counter-surface (15) of the counter-electrode (16) and in a third axial direction transverse to the advancing device of the lateral slider element (26).

6. The device according to claim 5,
**characterized in that**
the test head (27) can be pivoted by means of drive device (32), which is disposed at the lateral slider element (26), with respect to the lateral slider element (26).

7. The device according to any one of the previous claims,
**characterized in that**
the test head (27) comprises a contact element accommodation (41) having a hold-down device, which is disposed essentially parallel to the welding plane S, and a force transmission device for transmitting force to the contact element (12).

8. The device according to claim 7,
**characterized in that**
the contact element accommodation comprises a rotation stop effective against a rotation around the first axial direction.

9. The device according to claim 7,
**characterized in that**
the hold-down device is realized as an abutment surface (39) disposed parallel to the welding plane S, the rotation stop is realized as an abutment edge (38), and the force transmission device is realized as a stop edge (37).

10. The device according to any one of the previous claims,
**characterized in that**
a processing device, which enables a processing of a wire conductor connected to a contact element (12) or of a terminal connected to the contact element subsequent to the test procedure, is disposed adjacent to the compressing space (25).

11. The device according to claim 10,
**characterized in that**
the processing device is realized as a severing device (44) for severing the wire conductor (22).

12. The device according to claim 11,
**characterized in that**
the processing device is realized as a reshaping device for reshaping the terminal (22).

13. A method for producing a tested weld joint produced in a welding plane S between contact elements (11, 12), the compressing space (25) being opened subsequent to a welding procedure executed in a welding position of the contact elements (11, 12) in a compressing space (25), which is delimited by a work surface (13) of a sonotrode (14) transmitting ultrasonic oscillations and a counter-surface (15) of a counter-electrode (16) in a first axial direction at two opposing sides and by opposing delimiting elements in a second axial direction at two opposing sides via delimiting surfaces (17, 18),
**characterized in that**
a test head (27) disposed outside of the compressing space during the welding procedure, which is executed during the welding mode of the device and in which the compressing space (25) is closed by the sonotrode (14), is brought into a position within the open compressing space in a test mode of the device, in which the compressing space (25) is open, in order to execute a test procedure subsequent to the welding procedure, a contact element (12) of the weld joint remaining in the welding position being subjected to a shear force in the direction of an advancing axis of the test head in order to execute the test procedure and the other contact element (11) being retained on the counter-surface (15) in a fixating manner in the opposite direction of the advancing device of the test head (27), the test procedure being executed as a function of at least one process parameter determined during .

14. The method according to claim 13,
**characterized in that**
in order to execute the test procedure in the test mode of the device, the test head (27) is pivoted from a position disposed above the lateral slider element (26) in the welding mode of the device to a test position in the open compressing space (25).

15. The method according to claim 14,
**characterized in that**
in order to execute the test procedure, a force transmission device of the test head (27) is displaced so as to stop at the contact element (12) and the force is then steadily increased.

16. The method according to claim 15,
**characterized in that**
the advancing device of the test head is provided with a path measuring device in such a manner that the advancing path of the test head (27) is measured while the force is increased.

17. The method according to any one of the claims 13 to 16,
**characterized in that**
a contact element (12) is marked with a test marking while the test procedure is being executed.

18. The method according to any one of the claims 13 to 17,
**characterized in that**
during the test procedure, the force exerted via the test head (27) is measured and/or the advancing path of the test head (27) is measured and **in that** a wire conductor (24), which is connected to a contact element (12), is severed by means of a severing device (44) should a test force defined as a target value be fallen below or an advancing path defined as a maximal path be exceeded.

19. The method according to any one of the claims 13 to 17,
**characterized in that**
during the test procedure, the force exerted via the test head (27) is measured and/or the advancing path of the test head (27) is measured and **in that** a reshaping of a contact element (11, 12) for producing a mechanical joint between the contact element and a wire conductor (22), which is connected to the contact element, by means of a reshaping device acting upon the contact element (12) is suppressed should a test force defined as a target value be fallen below or an advancing path defined as a maximal path be exceeded.

## Revendications

1. Dispositif pour la production d'une connexion de soudage testée entre deux éléments de contact (11, 12) joints dans un plan de soudage S, le dispositif comprenant un espace de compression (25) pour la réception d'éléments de contact (11, 12), ledit espace de compression (25) étant limité aux deux côtés opposés par un plan de travail (13) d'une sonotrode (14), qui transmit des oscillations à ultrasons, et par une surface contraire (15) d'un électrode contraire (16) en un premier sens axial et étant limité aux deux côtés opposés par des surfaces de limitation (17, 18) des éléments de limitation opposés en un deuxième sens axial, et au moins un élément de limitation étant réalisé comme élément glissière latéral (26) qui est réalisé de manière à être déplaçable par rapport à l'électrode contraire (16) au moyen d'un dispositif d'avancement,
**caractérisé en ce que**
le dispositif comprend une tête de test (27) qui est adjacente à l'espace de compression (25) et est pourvue d'un dispositif d'avancement pour avancer la tête de test (27) vers un axe d'avancement parallèle au plan de soudage S, et **en ce que** la surface contraire (15) sert à recevoir un élément de contact (11) dans une manière fixée en le sens de l'axe d'avancement, ladite tête de test pouvant être transférée d'une position en dehors de l'espace de compression à une position dans l'espace de compression dans telle manière que la tête de test (27) est disposée dans l'espace de compression (25) ouvert dans un mode de test du dispositif pour la soumission de l'autre élément de contact (12) de la connexion de soudage précédemment produite à une force de cisaillement essentiellement orientée parallèlement au plan de soudage S, et **en ce que** la tête de test (27) est disposée en dehors de l'espace de compression (25) dans un mode de soudage du dispositif pour la production de la connexion de soudage, le dispositif d'avancement de la tête de test (27) étant formé par le dispositif d'avancement de l'élément glissière latéral (26).

2. Dispositif selon la revendication 1,
**caractérisé en ce que**
la tête de test (27) est disposée sur l'élément glissière latéral (26).

3. Dispositif selon la revendication 1 ou 2,
**caractérisé en ce que**
la tête de test (27) est disposée sur une tête glissière latérale (28) reliée à un porteur glissière latéral (30) de l'élément glissière latéral (26) d'une manière échangeable.

4. Dispositif selon la revendication 2 ou 3,
**caractérisé en ce que**
la tête de test (27) est reliée à l'élément glissière latéral (26) d'une manière pivotante.

5. Dispositif selon la revendication 4,
**caractérisé en ce que**
la tête de test (27) est reliée à l'élément glissière latéral (26) au moyen d'un axe de pivotement (31) s'étendant parallèlement à la surface contraire (15) de l'électrode contraire (16) et en un troisième sens axial transverse au sens d'avancement de l'élément glissière latéral (26).

6. Dispositif selon la revendication 5,
**caractérisé en ce que**
la tête de test (27) peut être pivotée au moyen d'un dispositif d'entraînement (32), qui est disposé sur l'élément glissière latéral (26), par rapport à l'élément glissière latéral (26).

7. Dispositif selon l'une quelconque des revendications précédentes,
**caractérisé en ce que**
la tête de test (27) comprend une réception (41) d'élément de contact ayant un dispositif à tenir à bas, qui est disposé essentiellement parallèlement au plan de soudage S, et un dispositif de transmission de force pour la transmission de la force à l'élément de contact (12).

8. Dispositif selon la revendication 7,
**caractérisé en ce que**
la réception d'élément de contact a un dispositif d'arrêt de rotation effectif contre une rotation autour le premier sens axial.

9. Dispositif selon la revendication 7,
**caractérisé en ce que**
le dispositif à tenir à bas est réalisé comme surface d'appui (39) disposée parallèlement au plan de soudage S et le dispositif d'arrêt de rotation est réalisé comme bord d'appui (38) et le dispositif de transmission de force est réalisé comme bord d'arrêt (37).

10. Dispositif selon l'une quelconque des revendications précédentes,
**caractérisé en ce**
**qu'**un dispositif de traitement, qui rende possible un traitement d'un conducteur électrique (43) relié à un élément de contact (12) ou d'un terminal relié à l'élément de contact suivant le procédé de test, est disposé adjacent à l'espace de compression (25).

11. Dispositif selon la revendication 10,
**caractérisé en ce que**
le dispositif de traitement est réalisé comme dispositif de coupure (44) pour couper le conducteur électrique (22).

12. Dispositif selon la revendication 11,
**caractérisé en ce que**
le dispositif de traitement est réalisé comme dispositif de déformation pour déformer le terminal (22).

13. Procédé pour la production d'une connexion de soudage testée produite dans un plan de soudage S entre des éléments de contact (11, 12), l'espace de compression (25) étant ouvert suivant un procédé de soudage exécuté dans une position de soudage des éléments de contact (11, 12) dans un espace de compression (25), qui est limité aux deux côtés par un plan de travail (13) d'un sonotrode (14) transmettant des oscillations à ultrasons et par une surface contraire (15) d'un électrode contraire (16) en un premier sens axial opposés et aux deux côtés opposés par des éléments de limitation opposés et par des surfaces de limitation (17, 18) en un deuxième sens axial,
**caractérisé en ce**
**qu'**une tête de test (27) disposée en dehors de l'espace de compression (25) pendant le procédé de soudage, qui est exécuté pendant le mode de soudage du dispositif et pendant lequel l'espace de compression est fermé par le sonotrode (14), est bougé dans une position dans l'espace de compression ouvert dans un mode de test du dispositif, dans lequel l'espace de compression (25) est ouvert, afin d'exécuter un procédé de test suivant le procédé de soudage, un élément de contact (12) de la connexion de soudage retenant dans la position de soudage étant soumis à une force de cisaillement dans en sens d'un axe d'avancement de la tête de test afin d'exécuter le procédé de test et l'autre élément de contact (11) étant retenu sur la surface contraire (15) d'une manière fixée dans le sens opposé du dispositif d'avancement de la tête de test (27), le procédé de test étant exécuté comme fonction d'au moins un paramètre de procédé déterminé pendant le procédé de soudage.

14. Procédé selon la revendication 13,
**caractérisé en ce**
**qu'**afin d'exécuter le procédé de test dans le mode de test du dispositif, la tête de test (27) est pivotée d'une position disposée au-dessus de l'élément glissière latéral (26) dans le mode de soudage du dispositif dans une position de test dans l'espace de compression (25) ouvert.

15. Procédé selon la revendication 14,
**caractérisé en ce**
**qu'**afin d'exécuter le procédé de test, un dispositif de transmission de force de la tête de test (27) est déplacé de manière à arrêter à l'élément de contact (12) et la force est augmentée continûment ensuite.

16. Procédé selon la revendication 15,
**caractérisé en ce que**
le dispositif d'avancement de la tête de test est pourvu d'un capteur de position de telle manière que le pas d'avancement de la tête de test (27) est mesuré pendant la force est augmentée.

17. Procédé selon l'une quelconque des revendications 13 à 16,
**caractérisé en ce**
**qu'**un élément de contact (12) est marqué avec un marquage de test pendant le procédé de test est exécuté.

18. Procédé selon l'une quelconque des revendications 13 à 17,
**caractérisé en ce que**
pendant le procédé de test, la force exercée par la tête de test (27) est mesurée et/ou le pas d'avancement de la tête de test (27) est mesuré et **en ce qu'**un conducteur électrique (24), qui est relié à un élément de contact (12), est coupé au moyen d'un dispositif de coupure (44) si une force de test définie comme valeur cible reste inférieure ou un pas d'avancement définie comme pas maximal est excédé.

19. Procédé selon l'une quelconque des revendications 13 à 17,
**caractérisé en ce que**
pendant le procédé de test, la force exercée par la tête de test (27) est mesurée et/ou le pas d'avancement de la tête de test (27) est mesuré et **en ce qu'**une déformation d'un élément de contact (11, 12) pour produire un joint mécanique entre l'élément de contact et un conducteur électrique (22), qui est relié à l'élément de contact, au moyen d'un dispositif de déformation agissant sur l'élément de contact (12) est supprimé si une force de test définie comme valeur cible reste inférieure ou un pas d'avancement définie comme pas maximal est excédé.
